Europäisches Patentamt

European Patent Office

Office européen des brevets

(19)

(11) Publication number: **0 390 494 B1**

(12) ## EUROPEAN PATENT SPECIFICATION

(45) Date of publication of patent specification :
21.06.95 Bulletin 95/25

(51) Int. Cl.⁶ : **H03F 3/193,** H03F 1/32

(21) Application number : **90303245.6**

(22) Date of filing : **27.03.90**

(54) **Wideband amplifier using fet.**

(30) Priority : **30.03.89 JP 80325/89**

(43) Date of publication of application :
**03.10.90 Bulletin 90/40**

(45) Publication of the grant of the patent :
**21.06.95 Bulletin 95/25**

(84) Designated Contracting States :
**DE FR GB**

(56) References cited :
**IEEE TRANSACTIONS ON MICROWAVE
THEORY AND TECHNIQUES, vol. 36, no. 6,
June 1988, pages 1023-1032, IEEE, New York,
NY, US; T.S. TAN et al.: "A low-distortion
K-band GaAs power FET"
IEEE MTT-S INTERNATIONAL MICROWAVE
SYMPOSIUM DIGEST, Las Vegas, Nevada, 9th
- 11th June 1987, vol. 2, pages 569-572, IEEE,
New York, US; G.-G. ZHOU et al.: "A GaAS
microwave MESFET with extremely low distor-
tion"**

(56) References cited :
**IEEE TRANSACTIONS ON MICROWAVE
THEORY AND TECHNIQUES, vol. MTT-28, no.
1, January 1980, pages 9-17, IEEE, New York,
US; J.A. HIGGINS et al.: "Analysis and im-
provement of intermodulation distortion in
GaAs power FET's"**

(73) Proprietor : **MATSUSHITA ELECTRIC
INDUSTRIAL CO., LTD.
1006, Kadoma
Kadoma-shi, Osaka-fu 571 (JP)**

(72) Inventor : **Nambu, Shutaro
2-51, Oriidai-3-chome
Uji-shi (JP)**
Inventor : **Yamashita, Yasuhisa
Minazukiso,
5-18, Tonomachi
Takatsuki-shi (JP)**
Inventor : **Goda, Kazuhide
6-2, Shoryuji
Nagaokakyo-shi (JP)**

(74) Representative : **Smith, Norman Ian et al
F.J. CLEVELAND & COMPANY
40-43 Chancery Lane
London WC2A 1JQ (GB)**

EP 0 390 494 B1

## Description

BACKGROUND OF THE INVENTION

The present invention concerns with a wideband amplifier which serves to reduce a second order distortion particularly in a UHF and a VHF bands.

In receiving multi-channel signals in a wide range, these signals are subject to mutual interference, thereby disadvantageously causing distortions of the signals. Those distortions result from nonlinearity of an active device in a signal processing circuit. Though a number of high degree distortions may be brought about, the second degree and third degree distortions are the most significant ones caused in the active device used for signal processing. In particular, in a system for receiving signals in a VHF to UHF band such as a front-end amplifier of a cable television converter or a RF (Noise Frequency) modulator connected with a booster used in a video tape recorder, the second order distortion has to be severely considered.

For wideband signal processing, a wideband bipolar transistor device or an FET (Field-Effect Transistor) consisting of a compound semiconductor may be employed. The bipolar transistor, however, has so inferior a noise figure that it gives rise to a large distortion of a signal. In recent days, hence, the system for processing signals in the VHF or UHF band often employs a compound semiconductor device such as a GaAs FET.

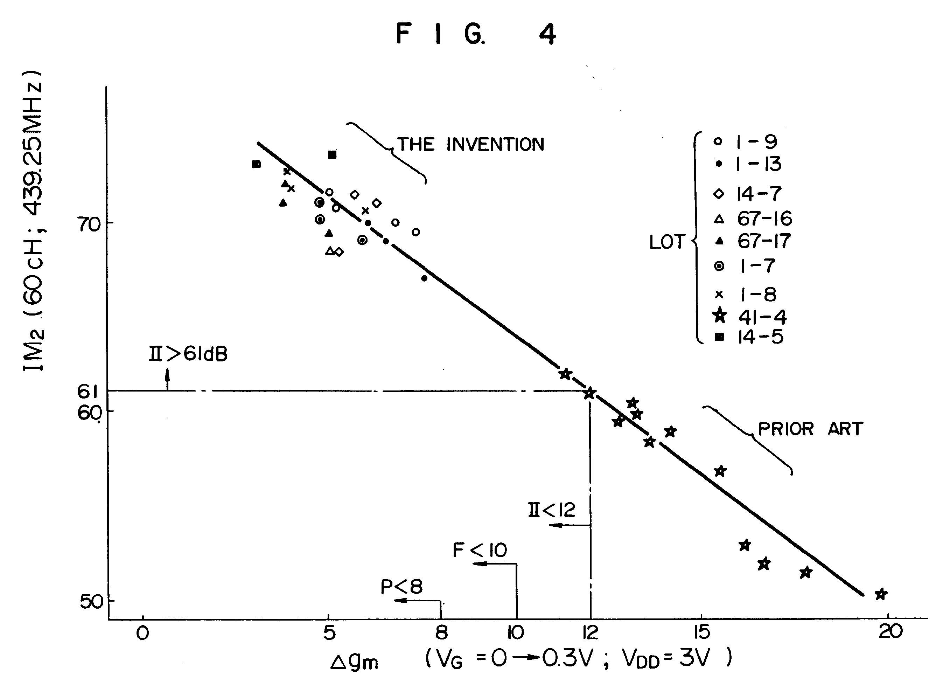

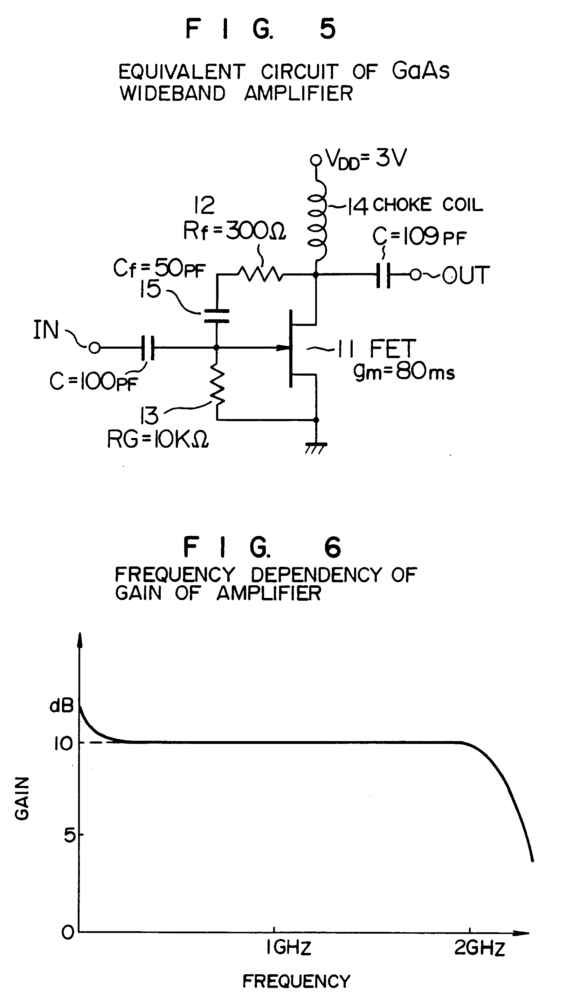

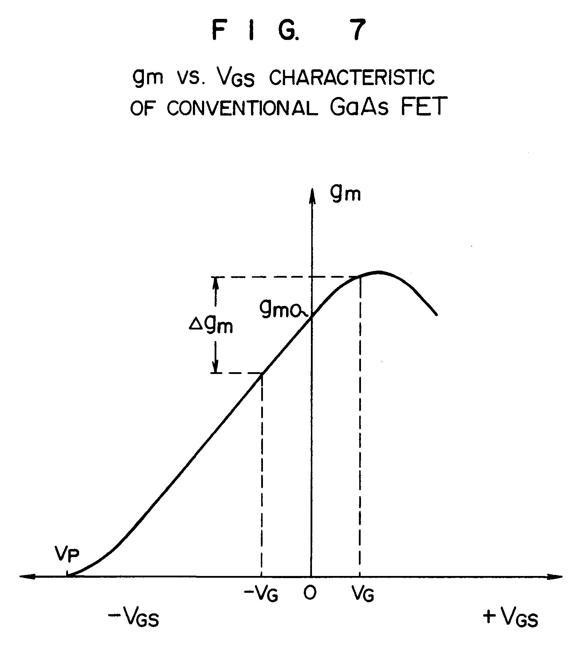

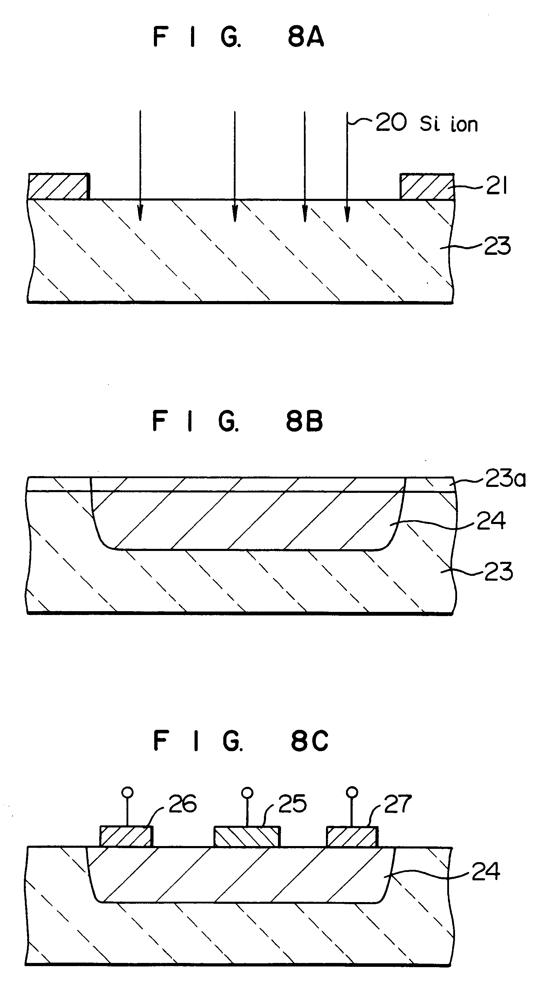

For describing such a wideband signal processing circuit, there can be referred a wideband amplifier having a territory of a VHF to UHF band, in particular, a negative feedback amplifier consisting of a compound semiconductor such as a GaAs FET. Fig. 5 is an equivalent circuit of the GaAs wideband amplifier. Fig. 6 shows an example of a frequency dependence of gain in this amplifier. It is assumed that a feedback resistance $R_f$ 12 is 300 $\Omega$, a gate bias resistance $R_G$ 13 is 10 k$\Omega$, FET 11 has a gate width of 800 $\mu$m, a gate length of 1 $\mu$m and a mutual conductance of 80 mS, and the consumed current $I_{DD}$ is about 30 mA. 14 denotes a choke coil $C_f$ for supplying bias current and 15 denotes a feedback capacitor for d.c. blocking.

When the wideband amplifier receives at an input terminal IN multi-channel signals over 64 to 80 channels (50 MH$_b$ to 500 MH$_b$) in the VHF to UHF band, nonlinearity entailed in an element itself gives rise to a second order and a third order distortions of a signal. As noted above, the wideband amplifier used for the cable television converter requires to have such distortions strictly suppressed. The conventional GaAs FET, in essence, has a feature that only a small third order distortion is brought about. The present inventors, however, have researched that a large second order distortion caused by the GaAs FET kills the superior feature of lowering a noise, thereby being unable to meet the satisfactory efficiency for the use.

For selecting an FET used for the amplifier, traditionally, high-frequency inspection has been manually done for a lot of manufactured GaAs FETs one by one for selecting an FET having a low noise and a small second order distortion, because it has been so difficult to obtain a GaAs FET having a small second order distortion and a low noise.

The inspected result was that just one satisfactory GaAs FET could be found among 70 FETs. This result indicates that it has been difficult to obtain a proper GaAs FET and the inspection has required a lot of labor and high cost. It means that the GaAs FET amplifier has not been so easily manufactured.

It has been recognised that second order distribution in an FET can be improved by flattening the characteristic of $g_m$ in relation to $V_{as}$ by selection of an appropriate doping profile in the active layer of the FET. This is described for example in IEEE Transactions on Microwave Theory and Techniques, Vol. 36, No. 6 Jan 1988, page 1023-1032, "A low-distortion-band GaAs power FET, and in IEEE MTT-S International Microwave Symposium Digest, 9th-11th June 1987, Vol. 2 pages 569-572: "A GaAs Microwave MESFET with extremely low distribution". Neither of these documents deal with wideband amplifiers.

SUMMARY OF THE INVENTION

It is an object of the present invention to provide a wideband amplifier which can provide an improved second order distortion characteristic.

It is another object of the present invention to provide an automatic inspecting process employing a low frequency or direct current which permits easy selection of an FET having a superior second order distortion characteristic in a VHF to VHF band.

According to one aspect of the present invention there is provided a wideband amplifier for receiving concurrently multi-channel signal in a predetermined frequency range and for amplifying the receiver signals, said wideband amplifier comprising a field effect transistor which has a gate, a drain and a source and is arranged to amplify the received signals, said transistor having a negative feedback circuit for feeding back a signal at said drain to said gate, and a gate bias circuit between said gate and said source for setting a gate bias of the field effect transistor, characterised in that said feedback circuit includes a feedback capacitor arranged to cut off a direct component of current between the gate and the drain and a feedback resistance, said gate bias circuit includes a gate bias resistance, and wherein

said field effect transistor formed by ion implantation, has a substantially flat characteristic of mutual conductance versus voltage between the gate and the source with respect to the center of an operation region to thereby suppress a second order intermodulation distortion of an output of said wideband amplifier.

According to a second aspect of the present invention there is provided a method of inspecting a field effect transistor for the wideband amplifier according to the first aspect of the invention in order to ensure a sufficient low level of second order distortion in a high frequency range, said method comprising the steps of:

applying two different voltages on an input terminal of a field effect transistor;

measuring a difference between mutual conductances relating to each of said predetermined voltages;

comparing said difference with a predetermined value; and

determining whether said field effect transistor is acceptable for the wideband amplifier according to whether said difference is lower than said predetermined value.

The present invention can offer a wideband amplifier having a superior second order distortion characteristic, because it employs a field-effect transistor having a flat mutual conductance to a voltage $V_{GS}$ between a gate and a source (referred to as gate-source voltage) is made flat with respect to the center of an operation point.

That is, in an amplifier which serves to concurrently receive multi-channel signals in a wide frequency range such as a UHF and a VHF band and amplify them, the present invention can offer a wideband amplifier which employs as an amplifying semiconductor element a field-effect transistor having a substantially flat characteristic of mutual conductance top the gate-source voltage with respect to the center of the operation point for suppressing second order distortion components in an output.

Further, the invention can offer a wideband amplifier which ensures suppression a second order distortion at a high frequency by inspecting the field-effect transistor and accepting it only if the difference between mutual conductances to applied voltages at an input terminal having a constant difference therebetween which is equal to or less than a constant value.

The invention will be described now by way of example only, with particular reference to the accompanying drawings. In the drawings:

## BRIEF DESCRIPTION OF THE DRAWINGS

Fig. 1 is a characteristic curve of $g_m$ to $V_{GS}$ in a GaAs FET according to one embodiment of the invention;

Fig. 2 is a curve showing a doping carrier profile of the FET according to the embodiment of the invention;

Fig. 3 is a section of the FET;

Fig. 4 is a graph showing $\Delta g_m$ - $IM_2$ relation of the FET;

Fig. 5 is an equivalent circuit diagram of a GaAs wideband amplifier;

Fig. 6 is a graph showing frequency dependence of a gain in the wideband amplifier;

Fig. 7 is a curve of $g_m$ - $V_{GS}$ relation of a conventional GaAs FET; and

Fig. 8 is a schematic view showing the manufacturing step of the GaAs FET.

## DESCRIPTION OF THE PREFERRED EMBODIMENTS

The principle of the invention is based on the fact experimentally found out by the present inventors, who have analyzed the characteristic of an FET composing a wideband amplifier and a second order distortion characteristic.

Traditionally, the second order distortion has resulted from nonlinearity of $g_m$ of an FET and gate capacitance. However, as a result of studying the relation between the proper characteristic of the FET and the second order distortion, the present inventors have found out that there exists large correlation between a difference $\Delta g_m$ between both mutual conductances $g_m$ to voltages applied at an input terminal and a second order distortion caused in the cable television converter.

Fig. 7 shows the relation between the mutual conductance $g_m$ and the gate-source voltage $V_{GS}$ of a compound semiconductor normally used in a wideband amplifier, for example, a GaAs field-effect transistor (FET). A normal GaAs FET has a gradient of $g_m$ as shown in Fig. 7. The FET is allowed to operate by setting an operation point on the curve with the gradient and applying a signal positioned between - $V_G$ to $V_G$ to a gate.

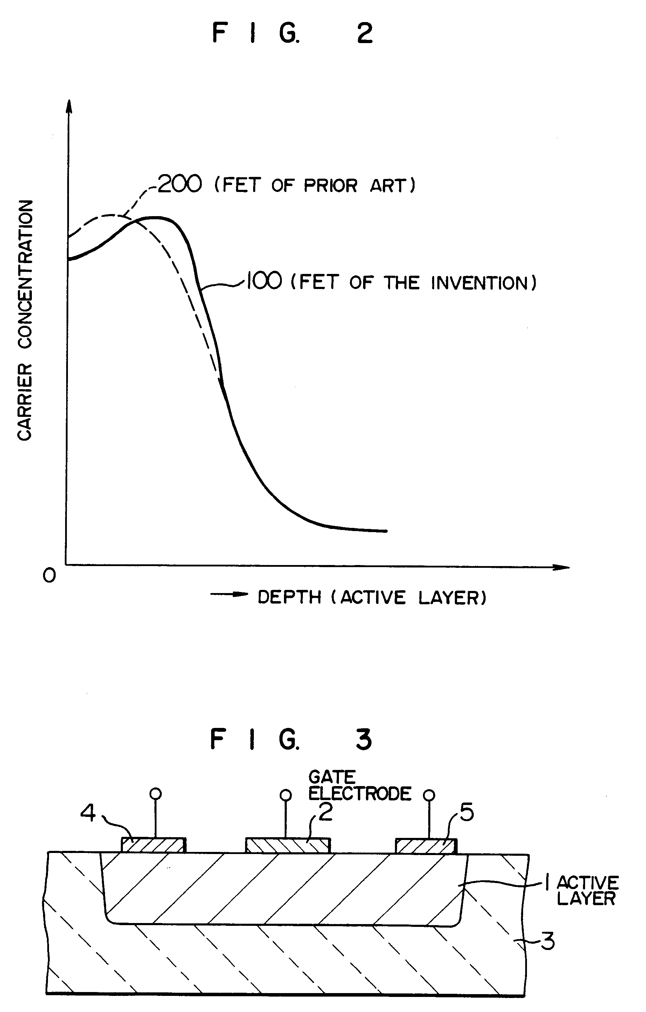

The present inventors have researched the relation between the difference $\Delta g_m$ between $g_m$ of $V_G = \pm 0.3$ V and a second order intermodulation distortion ($IM_2$) caused in the cable television converter. Fig. 4 shows the researched result.

The GaAs FET is normally manufactured by the process shown in Fig. 8. The process comprises the steps

EP 0 390 494 B1

of forming a mask 21 on a semi-insulated GaAs substrate; implanting Si-ion 20 as an impurity (A) for forming an active layer 24 in which the FET is formed; etching, that is, adjustably etching a surface portion 23a for realizing a proper characteristic (B); and forming a Schottky gate electrode 25, a source electrode 26, and a drain electrode 27 for forming an FET (C).

In addition, the Si-ion implantation condition except No. 41-4 is indicated in the below TABLE.

[TABLE]

| Implantation Condition LOT No. | Accelerating Voltage (keV) | Dose Amont ×$10^{12}$ cm⁻³ | Etching |
|---|---|---|---|
| 1 to 9 | 120 | 5 | 1000Å |
| 1 to 13 | 70 | 5 | 1000Å |
| 14 to 7 | 70 | 3 | 500Å |
| 67 to 16 | 70 | 5 | 1000Å |
| 67 to 17 | 120 | 3 | 400Å |
| 1 to 7 | 120 | 5 | 500Å |
| 1 to 8 | 120 | 3 | 200Å |
| 14 to 5 | 120 | 3 | 200Å |

Fig. 4 shows the relation between $\Delta g_m$ and a second order intermodulation distortion ($IM_2$) in a wideband amplifier employing an FET (trial lot No. 41-4 shown in Fig. 4) whose active layer 24 is formed by implanting Si-ion under the condition of 70 KeV accelerating voltage and $7 \times 10^{12}$ dose amount or an FET (any one except the trial lot No. 41-4) manufactured in such a trial and error manner as varying the Si-ion implantation condition.

As shown in Fig. 4, it is to be understood that as $\Delta g_m$ becomes smaller, $IM_2$ becomes more excellent. This result indicates the fact that as $\Delta g_m$ becomes smaller, that is, as the used FET has a more flat mutual conductance characteristic with respect to the center of the operation point, the second order intermodulation distortion ($IM_2$) becomes superior. This also indicates that the smallest value of the first order differential coefficient $\sigma g_m$-/$\sigma V_{GS}$ to the gate voltage $V_{GS}$ of $g_m$ is important to reducing $Im_2$. That is, it is found out the fact that the FET having a smaller gradient of $g_m$, in other words, a flat $g_m$ on the operation point has an effect on reduction of the $IM_2$. This fact has been found out by the present inventors.

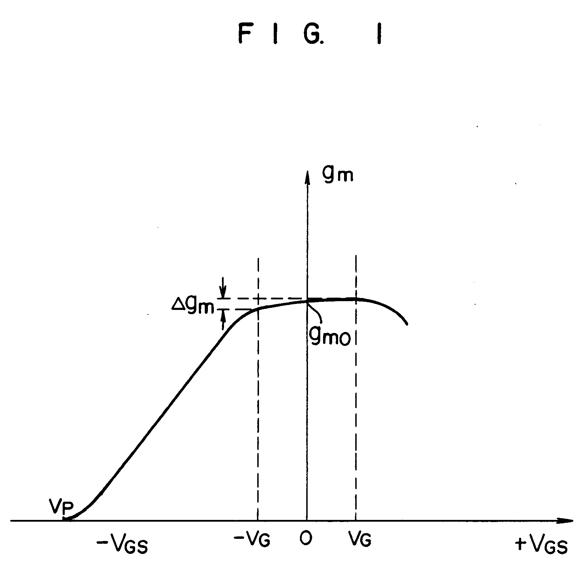

Hereinafter, a description will be directed to a wideband amplifier according to one embodiment of the invention employing a GaAs FET. The circuit diagram of the amplifier is identical to that shown in Fig. 5. In this diagram, $V_{GS} = 0$ V is denoted as an operation point. The present invention has the following greatly different point from the conventional one, wherein the used FET has a substantially flat area of $g_m$ with respect to the center of the operation point of $V_{GS} = 0v$ in the characteristic of $g_m$ (mutual conductance) to $V_{GS}$ (voltage between gate and source) as shown in Fig. 1. The value of $\Delta g_m$ is suppressed to be 8 mS or less in the range of $V_{GS} = 0V$ and 20% or less value of $g_{m0} = 70$ mS given in case of $V_{GS} = 0v$. The present invention employs the FET having the foregoing condition for its wideband amplifier.

The FET used in the invention is shown in Fig. 3. The FET shown in Fig. 3 is identical to that shown in Fig. 8 except the characteristic shown in Fig. 1. The carrier doping profile, as shown in Fig. 2, is smaller than the conventional one near the surface of the Schottky gate electrode 2 and is higher in a deep portion of the electrode 2. 100 denotes an FET carrier doping profile for the invention, 200 denotes a carrier doping profile for a conventional FET, 3 denotes a semi-insulated GaAs substrate, 4 denotes a source electrode, and 5 denotes a drain electrode.

4

The carrier doping profile 100 can be obtained by properly selecting any one except the LOT No. 41-4. For example, it could be implemented by using the Si-ion implantation condition of an accelerating voltage of 120 KeV and a dose amount of $3 \times 10^{12}$ cm$^{-3}$ and an FET gate width of 800 $\mu$m and adjustably etching the thickness of an active layer 1 so as to have a drain saturation current $I_{pss}$ of 30 to 50 mA. This FET gives a larger accelerating voltage and a smaller dose amount than the conventional FET for reducing the adjustably etched amount.

The foregoing ion implantation condition was obtained by doing a trial and error for searching the most proper condition among several conditions that $\Delta g_m$ shown in Fig. 4 becomes smaller. In general, by lowering the accelerating voltage, pushing a peak value into the depth of the active layer, reducing the dose amount, and reducing the adjustably etched amount, it is possible to leave a doping carrier profile near the surface, that is, the profile where a carrier density drops in the active layer of the device intact, resulting in being able to suppressing $\Delta g_m$ to be a small value.

This type of FET can be also implemented by providing a larger source resistance than the conventional FET. However, as the source resistance is made larger than a predetermined value, a value of $g_m$ is made smaller, thereby making the other characteristics such as a noise characteristic and a gain inferior. Hence, the source resistance has to be an optimal value.

It is well known that the relation between the source resistance and the $g_m$ of the device can be represented by the following equation:

$$g_m = g_{m0}/(1 + R_s g_{m0})$$

where $g_{m0}$ denotes a $g_m$ value of an intrinsic FET from which the source resistance is excluded. The equation indicates that when $R_s$ has a large value, $g_m$ can be suppressed to be a small value as $g_{m0}$ becomes larger. As a result, as shown in Fig. 1, the region where $\Delta g_m$ is small can be formed near the portion of $V_{GS}$ = 0v where $g_{m0}$ is large.

An excellent IM$_2$ characteristic was implemented when the wideband amplifier designed above (which is identical to the design shown in Fig. 5) is used as a front-end amplifier of the cable television converter. In this example, when the input signal level is -5dBm and the cable television converter receives 87-channel signals over its band, IM$_2$ is guaranteed to be 60 dB or more.

And, in order to make the IM$_2$ characteristic of the wideband amplifier more stable and excellent, traditionally, it has been necessary to follow the troublesome steps of performing d.c. inspection of the wideband amplifiers, applying-multi-channel signals to each successful wideband amplifier like the cable television converter, and actually measuring an IM$_2$ value of each wideband amplifier for guaranteeing a proper IM$_2$ characteristic of the wideband amplifier, because the correlation between the Im$_2$ and the d.c. characteristic has been made unobvious.

The aforementioned researched result, however, indicates that the IM$_2$ characteristic has strong correlation with $\Delta g_m$ to be easily measured by the d.c. automatic inspection. Hence, for guaranteeing the IM$_2$ characteristic, the acceptance quality level was assumed as follows: the difference $\Delta g_m$ between a $g_m$ in case of $V_{GS}$ = 0.15 V and a $g_m$ in case of $V_{GS}$ = -0.15 V has to reside within 30% of $g_{m0}$, that is, a $g_m$ in case of $V_{GS}$ = 0v. Concretely, the difference $\Delta g_m$ has to be 8 ms or lower. Since the inspection can be automated by using a low frequency or a direct current, it is possible to guarantee the IM$_2$ characteristic to be a constant value or more merely by doing IM$_2$ spot check using a high frequency, resulting in greatly lowering the cost of the inspecting process. This method is found out by the present inventors and makes great contribution to easy implementation of a wideband amplifier designed for suppressing a second order distortion.

As has been obvious from the above description, the present invention allows implementation of a low-distortion and low-noise wideband amplifier consisting of a GaAs FET. And, since the invention is capable of guaranteeing a second order distortion with the low-frequency automatic inspection, the inspecting cost can be greatly reduced, so that it is possible to easily implement the wideband amplifier which is excellent in a second order characteristic at low cost, resulting in making great contribution to implementation of a high-efficient wideband amplifier.

## Claims

1.  A wideband amplifier for receiving concurrently multi-channel signal in a predetermined frequency range and for amplifying the receiver signals, said wideband amplifier comprising a field effect transistor (11) which has a gate, a drain and a source and is arranged to amplify the received signals, said transistor (11) having a negative feedback circuit (12, 15) for feeding back a signal at said drain to said gate, and a gate bias circuit (13) between said gate and said source for setting a gate bias of the field effect transistor (11), characterised in that said feedback circuit includes a feedback capacitor (15) arranged to cut off a direct component of current between the gate and the drain and a feedback resistance (12), said gate bias circuit includes a gate bias resistance (13), and wherein

said field effect transistor (11), formed by ion implantation, has a substantially flat characteristic of mutual conductance ($g_m$) versus voltage ($V_{GS}$) between the gate and the source with respect to the center of an operation region to thereby suppress a second order intermodulation distortion ($IM_2$) of an output of said wideband amplifier.

2. A wideband amplifier according to claim 1, wherein said predetermined frequency range is a UHF and/or a VHF frequency range and said field effect transistor (11) is formed from GaAs substrate.

3. A wideband amplifier according to claim 1 or claim 2, wherein said field effect transistor (11) has an active layer (1) having a carrier doping profile in which the carrier concentration is lower near a surface of the gate electrode (2) and is higher in a deeper portion of the active layer compared with a conventional field effect transistor, said field effect transistor having formed by controlling the condition of ion implantation to a semiconductor substrate.

4. A method of inspecting a field effect transistor for the wideband amplifier according to claims 1 to 3 in order to ensure a sufficient low level of second order distortion in a high frequency range, said method comprising the steps of:
applying two different voltages on an input terminal of a field effect transistor;
measuring a difference between mutual conductances relating to each of said predetermined voltages;
comparing said difference with a predetermined value; and
determining whether said field effect transistor is acceptable for the wideband amplifier according to whether said difference is lower than said predetermined value.

**Patentansprüche**

1. Breitbandverstärker zum gleichzeitigen Empfangen eines Vielkanalsignals in einem vorbestimmten Frequenzbereich und zum Verstärken der Empfängersignale, wobei der Breitbandverstärker einen Feldeffekttransistor (11) umfaßt, welcher einen Gate-Kontakt, einen Drain-Kontakt und einen Source-Kontakt aufweist und zum Verstärken der empfangenen Signale ausgelegt ist, wobei der Transistor (11) eine negative Rückkopplungsschaltung (12, 15) zum Rückkoppeln eines Signals an dem Drain-Kontakt zu dem Gate-Kontakt und eine Gate-Vorspannungsschaltung (13) zwischen dem Gate-Kontakt und dem Source-Kontakt zum Einstellen einer Gate-Vorspannung des Feldeffekttransistors (11) aufweist, dadurch gekennzeichnet, daß die Rückkopplungsschaltung einen Rückkopplungskondensator (15), der zum Absperren einer Gleichstromkomponente zwischen dem Gate-Kontakt und dem Drain-Kontakt ausgelegt ist, und einen Rückkopplungswiderstand (12) einschließt, und daß die Gate-Vorspannungsschaltung einen Gate-Vorspannungswiderstand (13) einschließt, und wobei
der Feldeffekttransistor (11), der durch Ionenimplantation hergestellt ist, eine im wesentlichen flache Charakteristik von Steilheit ($g_m$) gegen Spannung ($V_{GS}$) zwischen dem Gate-Kontakt und dem Source-Kontakt bezüglich der Mitte eines Arbeitsbereiches aufweist, um dadurch eine Intermodulationsverzerrung zweiter Ordnung ($IM_2$) eines Ausgangssignals des Breitbandverstärkers zu unterdrücken.

2. Breitbandverstärker nach Anspruch 1, bei dem der vorbestimmte Frequenzbereich ein UHF- und/oder ein VHF-Frequenzbereich ist und der Feldeffekttransistor (11) aus einem GaAs-Substrat hergestellt ist.

3. Breitbandverstärker nach Anspruch 1 oder 2, bei dem der Feldeffekttransistor (11) eine aktive Schicht (1) mit einem Trägerdotierprofil aufweist, bei welchem die Trägerkonzentration nahe einer Oberfläche der Gate-Elektrode (2) niedriger ist und in einem tieferen Abschnitt der aktiven Schicht höher ist, und zwar verglichen mit einem konventionellen Feldeffekttransistor, wobei der Feldeffekttransistor hergestellt worden ist, indem die Bedingungen der Ionenimplantation in ein Halbleitersubstrat gesteuert worden sind.

4. Verfahren des Prüfens eines Feldeffekttransistors für den Breitbandverstärker nach den Ansprüchen 1 bis 3, um einen hinreichend niedrigen Pegel der Verzerrung zweiter Ordnung in einem Hochfrequenzbereich sicherzustellen, wobei das Verfahren die Schritte umfaßt:
Anlegen zweier verschiedener Spannungen an einen Eingangsanschluß eines Feldeffekttransistors;

Messen einer Differenz zwischen auf jede der vorbestimmten Spannungen bezogenen Steilheiten;

Vergleichen der Differenz mit einem vorbestimmten Wert; und

Bestimmen, ob der Feldeffekttransistor für den Breitbandverstärker verwertbar ist, abhängig davon, ob die Differenz kleiner als der vorbestimmte Wert ist.

## Revendications

1. Amplificateur à large bande, destiné à recevoir simultanément des signaux de canaux multiples dans une bande de fréquences prédéterminée et à amplifier les signaux reçus, ledit amplificateur à large bande comprenant un transistor à effet de champ (11) qui comporte une grille, un drain et une source et qui est agencé de façon à amplifier les signaux reçus, ledit transistor (11) comportant un circuit de réaction négative (12, 15) pour réinjecter sur ladite grille un signal présent sur ledit drain et un circuit de polarisation de grille (13) entre ladite grille et ladite source pour établir une polarisation de grille du transistor à effet de champ (11), caractérisé en ce que ledit circuit de réaction négative contient un condensateur de réaction (15), agencé de façon à couper une composante continue de courant entre la grille et le drain, et une résistance de réaction (12), ledit circuit de polarisation de grille contient une résistance de polarisation de grille (13), et en ce que ledit transistor à effet de champ (11), formé par implantation d'ions, a une caractéristique pratiquement plate de conductance mutuelle ($g_m$) en fonction de la tension ($V_{GS}$) entre la grille et la source, en ce qui concerne le milieu d'une région de fonctionnement, de façon à supprimer une distorsion d'intermodulation de second ordre ($IM_2$) d'un signal de sortie dudit amplificateur à large bande.

2. Amplificateur à large bande selon la revendication 1, dans lequel ladite bande de fréquences prédéterminée est une bande de fréquences UHF et/ou VHF et ledit transistor à effet de champ (11) est formé à partir d'un substrat de GaAs.

3. Amplificateur à large bande selon la revendication 1 ou 2, dans lequel ledit transistor à effet de champ (11) comporte une couche active (1) ayant un profil de dopage en porteurs dans lequel la concentration des porteurs est plus faible près d'une surface de l'électrode de grille (2) et est plus élevée dans une partie plus profonde de la couche active en comparaison d'un transistor à effet de champ classique, ledit transistor à effet de champ étant formé par contrôle des conditions d'implantation d'ions dans un substrat semi-conducteur.

4. Procédé de contrôle d'un transistor à effet de champ pour l'amplificateur à large bande selon l'une quelconque des revendications 1 à 3, afin de s'assurer d'un niveau suffisamment bas de distorsion de second ordre dans une bande de hautes fréquences, ledit procédé comprenant les étapes consistant

à appliquer deux tensions différentes à une borne d'entrée d'un transistor à effet de champ;

à mesurer la différence entre les conductances mutuelles se rapportant respectivement auxdites tensions prédéterminées;

à comparer ladite différence à une valeur prédéterminée; et

à décider si ledit transistor à effet de champ est acceptable pour l'amplificateur à large bande selon que ladite différence est inférieure ou non à ladite valeur prédéterminée.

F I G.  I

# F I G. 2

CARRIER CONCENTRATION

200 (FET OF PRIOR ART)

100 (FET OF THE INVENTION)

O

→ DEPTH (ACTIVE LAYER)

# F I G. 3

GATE
ELECTRODE

4    2    5

I ACTIVE
LAYER

3

9

F I G. 4

# F I G. 5

## EQUIVALENT CIRCUIT OF GaAs WIDEBAND AMPLIFIER

# F I G. 6

## FREQUENCY DEPENDENCY OF GAIN OF AMPLIFIER

11

# F I G. 7

## gm vs. V$_{GS}$ CHARACTERISTIC OF CONVENTIONAL GaAs FET

F I G. 8A

20 Si ion

21

23

F I G. 8B

23a

24

23

F I G. 8C

26    25    27

24